# EUROPEAN PATENT SPECIFICATION

(11) **EP 3 862 390 B1**
(45) Date of publication and mention of the grant of the patent: **20.03.2024**
(21) Application number: 19869319.4
(22) Date of filing: 20.09.2019
(51) Int. Cl.: C08L 15/00, B32B 15/08, B32B 27/30, B32B 27/34, B32B 27/38, C08K 3/013, C08L 53/02, C08L 63/00, C08L 79/08, H01L 23/29, H01L 23/31, H05K 1/05, C09D 151/04, C09J 151/04

(54) **RESIN COMPOSITION, SUBSTRATE-ATTACHED FILM, METAL/RESIN LAMINATED BODY AND SEMICONDUCTOR DEVICE**
HARZZUSAMMENSETZUNG, SUBSTRATGEBUNDENER FILM, METALL-/HARZLAMINIERTER KÖRPER UND HALBLEITERBAUELEMENT
COMPOSITION DE RÉSINE, FILM FIXÉ À UN SUBSTRAT, CORPS STRATIFIÉ MÉTAL/RÉSINE ET DISPOSITIF SEMI-CONDUCTEUR

(30) Priority: 02.10.2018 JP 2018187515
(43) Date of publication of application: 11.08.2021
(73) Proprietor: Namics Corporation, Niigata-shi, Niigata 950-3131 (JP)
(72) Inventor: KOMATSU, Fumikazu, Niigata-shi, Niigata 950-3131 (JP); AOKI, Issei, Niigata-shi, Niigata 950-3131 (JP); TAKASUGI, Hiroshi, Niigata-shi, Niigata 950-3131 (JP); KUSAMA, Munetoshi, Niigata-shi, Niigata 950-3131 (JP)
(74) Representative: Zimmermann, Tankred Klaus
(86) International application number: PCT/JP2019/036961
(87) International publication number: WO 2020/071153

(56) References cited:
- WO-A1-2018/097010
- JP-A- 2001 152 016
- JP-A- 2015 224 304
- JP-A- 2017 210 546
- JP-A- 2018 090 664
- JP-A- 2018 130 938

## Description

### TECHNICAL FIELD

An aspect of the present disclosure relates to a resin composition used as an insulating adhesive layer. Also, an aspect of the present disclosure relates to a film with a substrate, a metal/resin laminated body, and a semiconductor device, each including the resin composition.

### BACKGROUND ART

In general illumination and automobile illumination, heat dissipation design has become important. For improving heat dissipation performance, a metal base substrate plate including aluminum or copper is widely used. A metal base substrate plate generally has a structure in which an insulating layer (insulating adhesive layer) is placed onto a metal member (aluminum or copper), and copper foil as a conductor is further placed thereon. A pattern is formed to this copper foil. An electronic part such as an LED is mounted by solder.

For example, thermal conductivity of the insulating layer is enhanced by adding a thermally conductive filler. Especially, an aluminum base substrate plate based on aluminum, as a metal member, is significantly influenced by the expansion and contraction of aluminum caused by temperature change. This sometimes causes cracks (solder cracks) to occur in a solder portion where an electronic part such as an LED has been mounted. It is considered that a method for reducing solder cracks includes a method of reducing the elasticity of the insulating layer such that the influence on solder by metal expansion and contraction is mitigated by the insulating layer (see JP 2015-98504 A). In general, an insulating layer has higher elasticity as the temperature is lower. Therefore, when the elastic modulus of an insulating layer is low at low temperature, it is effective in suppressing solder cracks. Especially, a substrate plate used in automobiles or the like is sometimes used in cold climate areas. Therefore, it is important that the elasticity of an insulating layer is also low in the low temperature region of 0°C or lower. On the other hand, heat resistance to endure solder mounting and adhesiveness to a metal member are also understandably important for an insulating layer used to a substrate plate.

JP 2018-130938 A, JP 2015-224304 A, and JP 2017-210546 A disclose resin compositions used in different applications.

### SUMMARY OF THE INVENTION

### PROBLEMS TO BE SOLVED BY THE INVENTION

An objective of the present disclosure is to provide a resin composition as described below, which is suitable for an insulating adhesive layer to an aluminum base substrate plate. A cured product of this resin composition is low in elasticity in the low temperature region of 0°C or lower. In addition, this resin composition has both heat resistance and adhesiveness.

### SOLUTION TO PROBLEMS

For achieving the above-described objective, a resin composition (the present resin composition) provided according to an aspect of the present disclosure contains
(A) a modified elastomer having an acid anhydride group,
(B) a solvent-soluble polyimide resin, and
(C) an epoxy resin., wherein
   the (B) is preferably a polyimide resin obtained by causing a tetracarboxylic acid component and dimer diamine to react.

In the present resin composition, the (A) is preferably a maleic anhydride-modified styrene-based elastomer.

In the present resin composition, the content of the (A) is 40% by mass or more, in terms of % by mass relative to a total solid content mass of the (A), the (B), and the (C).

The present resin composition preferably further contains (D) an inorganic filler.

Also, in the present resin composition, the (D) is preferably a thermally conductive filler having a coefficient of thermal conductivity of 10 W/m·K or more.

Also, as another aspect of the present disclosure, there is provided a film with a substrate, including a plastic substrate and a layer that contains the present resin composition and that is formed on at least one surface of the plastic substrate.

Also, as another aspect of the present disclosure, there is provided a metal/resin laminated body, including a metal plate or metal foil and a layer that contains the present resin composition and that is formed on at least one surface of the metal plate or metal foil.

Also, as another aspect of the present disclosure, there is provided a resin cured product which is a cured product of the present resin composition.

Also, as another aspect of the present disclosure, there is provided a semiconductor device including the present resin composition.

### EFFECTS OF INVENTION

A cured product of the present resin composition is low in elasticity in the low temperature region of 0°C or lower. In addition, the present resin composition has both heat resistance and adhesiveness. Therefore, the present resin composition is suitable for an insulating adhesive layer to an aluminum base substrate plate.

### DESCRIPTION OF EMBODIMENTS

Hereinafter, an embodiment of the present disclosure will be described in detail.

The resin composition according to an embodiment of the present disclosure contains (A) a modified elastomer having an acid anhydride group, (B) a solvent-soluble polyimide resin, and (C) an epoxy resin.

The components of the resin composition according to an embodiment of the present disclosure will be each described below.

### (A) Modified elastomer having an acid anhydride group

The modified elastomer having an acid anhydride group of component (A) can be produced by, for example, causing an acid anhydride and peroxide to react with an elastomer. Examples of the modified elastomer having an acid anhydride group include maleic anhydride-modified styrene-based elastomers such as a maleic anhydride-modified SEBS (polystyrene/polyethylene/polybutylene/polystyrene) copolymer, a maleic anhydride-modified SBS (polystyrene/polybutadiene/polystyrene) copolymer, a maleic anhydride-modified SEPS (polystyrene/polyethylene/polypropylene/polystyrene) copolymer, a maleic anhydride-modified SEP (polystyrene/polyethylene/polypropylene) copolymer, and a maleic anhydride-modified SIS (polystyrene/polyisoprene/polystyrene), a maleic anhydride-modified ethylene-propylene copolymer, a maleic anhydride-modified ethylene-butene copolymer, a maleic anhydride-modified ethylene-methyl acrylate copolymer, a maleic anhydride-modified ethylene-ethyl acrylate copolymer and a maleic anhydride-modified ethylene-butyl acrylate copolymer.

Component (A) is preferably a maleic anhydride-modified styrene-based elastomer. The maleic anhydride-modified styrene-based elastomer resin is particularly preferably maleic anhydride-modified SEBS.

The acid number of component (A) is preferably 0.1 mg CH₃ONa/g or more and more preferably 1 mg CH₃ONa/g or more. When the acid number is 0.1 mg CH₃ONa/g or more, the adhesive composition can be sufficiently cured and can have good adhesiveness and heat resistance.

The styrene ratio of the maleic anhydride-modified styrene-based elastomer is preferably 40% or less, more preferably 30% or less, further preferably 28% or less, and particularly preferably 25% or less. When the styrene ratio is excessively high, the elastic modulus of a cured product of the resin composition in the low temperature region of 0°C or lower becomes high, and there is concern about the occurrence of solder cracks.

The content of component (A), in terms of % by mass relative to a total solid content mass of component (A), component (B), and component (C), is preferably 40% to 95%, more preferably 70 to 95%, and further preferably 80% to 95%. When the content of component (A) is less than 40%, the elastic modulus of a cured product of the resin composition in the low temperature region of 0°C or lower becomes high, and there is concern about the occurrence of solder cracks. When the content of component (A) is more than 95%, the content of other components relatively decreases, and there is a possibility that solder heat resistance might deteriorate.

### (B) Solvent-soluble polyimide resin

The solvent-soluble polyimide resin of component (B) is not particularly limited in terms of its structure and the like, as long as it is soluble in a solvent. "Soluble" means that 20% by mass or more dissolves at 23 °C in at least one type of solvent selected from the following solvents. The solvents are toluene and xylene as a hydrocarbon-based solvent, acetone, methyl ethyl ketone, methyl isobutyl ketone, cyclohexanone, and cyclopentanone as a ketone-based solvent, 1,4-dioxane, tetrahydrofuran, and diglyme as an ether-based solvent, methyl cellosolve, ethyl cellosolve, propylene glycol monomethyl ether, propylene glycol monoethyl ether, propylene glycol monobutyl ether, and diethylene glycol methyl ethyl ether as a glycol ether-based solvent, ethyl acetate, butyl acetate, ethyl lactate, and gammabutyrolactone as an ester-based solvent, benzyl alcohol, N-methylpyrrolidone, N,N-dimethylformamide, and N,N-dimethylacetamide.

The solvent-soluble polyimide resin of component (B) can be obtained by causing diamine and a tetracarboxylic acid component to react at a temperature of 130°C or higher for an imidization reaction. The solvent-soluble polyimide resin of component (B) is preferably a polyimide resin obtained by causing a tetracarboxylic acid component and dimer diamine to react. This polyimide resin is excellent in adhesiveness, flexibility, toughness, and heat resistance. Also, in the solvent-soluble polyimide resin of component (B), dimer diamine may be partly substituted with silicone diamine.

Examples of the tetracarboxylic acid component used herein include pyromellitic acid dianhydride, 3,3',4,4'-benzophenonetetracarboxylic acid dianhydride, 3,3',4,4'-diphenylsulfonetetracarboxylic acid dianhydride, 1,4,5,8-naphthalenetetracarboxylic acid dianhydride, 2,3,6,7-naphthalenetetracarboxylic acid dianhydride, 3,3',4,4'-diphenylethertetracarboxylic acid dianhydride, 3,3',4,4'-dimethyldiphenylsilanetetracarboxylic acid dianhydride, 3,3',4,4'-tetraphenylsilanetetracarboxylic acid dianhydride, 1,2,3,4-furantetracarboxylic acid dianhydride, 4,4'-bis(3,4-dicarboxyphenoxy)diphenylsulfide dianhydride, 4,4'-bis(3,4-dicarboxyphenoxy)diphenylsulfone dianhydride, 4,4'-bis(3,4-dicarboxyphenoxy)diphenylpropane dianhydride, 3,3',4,4'-perfluoroisopropylidenediphthalic acid dianhydride, 3,3',4,4'-biphenyltetracarboxylic acid dianhydride, bis(phthalic acid)phenylphosphine oxide dianhydride, p-phenylene-bis(triphenylphthalic acid) dianhydride, m-phenylene-bis(triphenylphthalic acid) dianhydride, bis(triphenylphthalic acid)-4,4'-diphenylether dianhydride, bis(triphenylphthalic acid)-4,4'-diphenylmethane dianhydride, and 4,4'-(4,4'-isopropylidenediphenoxy)diphthalic acid dianhydride.

Also, examples of the dimer diamine include Versamine 551 (trade name, manufactured by BASF Japan Ltd.; 3,4-bis(1-aminoheptyl)-6-hexyl-5-(1-octenyl)cyclohexene) and Versamine 552 (trade name, manufactured by Cognis Japan Co., Ltd.; hydrogenated product of Versamine 551), as well as PRIAMINE 1075 and PRIAMINE 1074 (trade names, manufactured by Croda Japan KK).

The solvent-soluble polyimide resin of component (B) has a structure in which a tetracarboxylic acid component and dimer diamine have reacted to be polymerized by an imide bond. Dimer acid, which is a raw material of dimer diamine, is obtained by dimerizing an unsaturated fatty acid having 18 carbon atoms (a mixture of oleic acid, linoleic acid, linolenic acid, and the like). Depending on the reaction probability in dimerizing, products having a linear chain, an alicycle, an alicycle having a double bond, or an aromatic ring and the like are generated. The above-described dimer acid is a mixture thereof. Aminized product of this mixture is dimer diamine. Therefore, the molecular structure of the solvent-soluble polyimide resin of component (B) obtained by polymerizing a tetracarboxylic acid component and dimer diamine is a structure in which molecules of dimer acid as a mixture are irregularly bound. Such a structure is complicated and difficult to identify. Examples of an inferable molecular structure are structures represented by the following chemical structural formulae. It is considered that the molecular structure is a mixture thereof (these structural formulae are nothing more than examples. The molecular structure is not limited thereto).

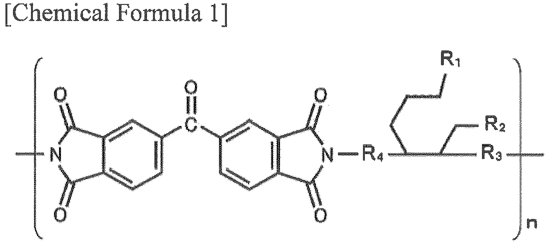

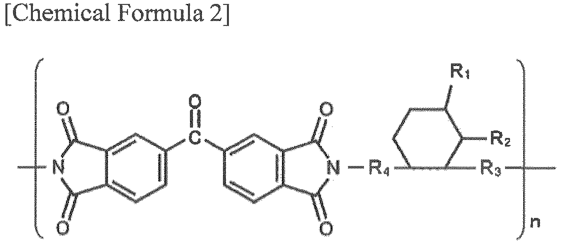

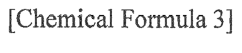

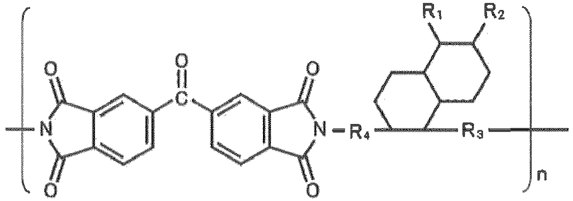

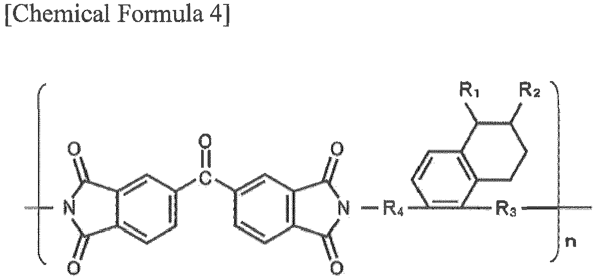

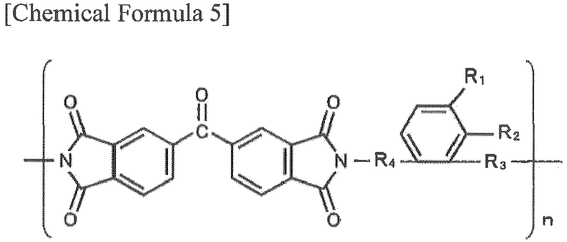

In the above-described chemical formulae, n represents an integer, and R₁, R₂, R₃, and R₄ each represent an organic group. As an example, R₁ and R₂ each represent - (CH₂)ₙ₁-(CH=Cₙ₂-(CH₂)ₙ₃-CH₃) and may be the same as or different from each other. R₃ and R₄ each represent (CH₂)ₙ₁-(CH=CH)ₙ₂-(CH₂)ₙ₃- and may be the same as or different from each other. n₁ and n₃ are each an integer of 0 to 18, and n₂ is an integer of 0, 1, or 2. Also, the number of carbons in the dimer diamine component is 36 in total. In the solvent-soluble polyimide resin of component (B), the number average molecular weight (Mn) is preferably 10,000 to 20,000 and more preferably 12,000 to 18,000. The number average molecular weight can be calculated by GPC measurement.

The content of component (B), in terms of % by mass relative to a total solid content mass of component (A), component (B), and component (C), is preferably 1% to 45%, more preferably 2 to 30%, and further preferably 5 to 15%. When the content of component (B) is more than 45%, the elastic modulus of a cured product of the resin composition in the low temperature region of 0°C or lower becomes high, and there is concern about the occurrence of solder cracks. On the other hand, when the content of component (B) is less than 1%, there is concern about a decrease in adhesiveness and a decrease in solder heat resistance.

### (C) Epoxy resin

Examples of the epoxy resin of component (C) include a bisphenol A type epoxy resin, a bisphenol F type epoxy resin, a phenol novolac-type epoxy resin, an alicyclic epoxy resin, a siloxane type epoxy resin, a biphenyl type epoxy resin, a glycidyl ester type epoxy resin, a glycidyl amine type epoxy resin, a hydantoin type epoxy resin, an epoxy resin having a naphthalene backbone, and an epoxy resin having an anthracene backbone. Also, the epoxy resin of component (C) may be an epoxy resin having a high molecular weight, like a phenoxy type epoxy resin.

For the resin composition of the present embodiment, the compounds described as examples here may be used individually, or two or more of the compounds may be mixed and used. The epoxy equivalent weight of component (C) is preferably 80 to 20,000 g/eq, more preferably 90 to 17,000 g/eq, and further preferably 90 to 500 g/eq.

The content of component (C), in terms of % by mass relative to a total solid content mass of component (A), component (B), and component (C), is preferably 1% or more and more preferably 3 to 15%. When the content of component (C) is less than 1%, there is concern about a decrease in solder heat resistance.

The resin composition of the present embodiment may further contain the following components as an optional component.

### (D) Inorganic filler

The inorganic filler of component (D) is preferably at least one selected from silica, barium sulfate, calcium carbonate, talc, kaolin, clay, boron nitride, silicon nitride, aluminum nitride, silicon carbide, magnesium oxide, magnesium hydroxide, magnesium carbonate, aluminum hydroxide, and alumina.

The inorganic filler of component (D) is appropriately selected depending on the required properties of the resin composition according to the present embodiment. For example, when emphasis is placed on reducing the coefficient of thermal expansion (CTE) of a cured product of the resin composition, the inorganic filler of component (D) is preferably silica.

On the other hand, when emphasis is placed on enhancing the thermal conductivity of a cured product of the resin composition, an inorganic filler having a coefficient of thermal conductivity of 10 W/m·K or more is preferably used as the inorganic filler of component (D).

Examples of the filler having a coefficient of thermal conductivity of 10 W/m·K or more include aluminum oxide (alumina, Al₂O₃), magnesium oxide (MgO), zinc oxide (ZnO), boron nitride (BN), silicon carbide (SiC), aluminum nitride (AlN), silicon nitride (Si₃ N₄), and diamond. From the viewpoint of the coefficient of thermal conductivity and the durability to humidity or the like, the filler having a coefficient of thermal conductivity of 10 W/m·K or more is preferably at least one selected from the group consisting of aluminum oxide and boron nitride. An example of the measurement result of a coefficient of thermal conductivity is indicated below for each material (unit: W/m·K). The coefficient of thermal conductivity for Al₂O₃ is 20 to 40. The coefficient of thermal conductivity for MgO is 45 to 60. The coefficient of thermal conductivity for ZnO is 54. The coefficient of thermal conductivity for BN is 30 to 80. The coefficient of thermal conductivity for SiC is 140 to 170. The coefficient of thermal conductivity for AlN is 150 to 250. The coefficient of thermal conductivity for Si₃N₄ is 30 to 80. The coefficient of thermal conductivity for diamond is 1000 to 2000.

The shape of the inorganic filler of component (D) is not particularly limited and may be any form such as spherical, indefinite, and scaly. As the inorganic filler of component (D), an aggregate may be used.

The average particle size of the inorganic filler of component (D) is preferably 0.1 to 100 µm, more preferably 0.1 to 50 µm, and further preferably 1 to 50 µm.

As described herein, the average particle size is a particle size at an integrated value of 50% in a volume-based particle size distribution measured by a laser diffraction scattering method. The average particle size can be measured by, for example, a laser scattering diffraction particle size distribution measuring device: LS13320 (Beckman Coulter, Inc., wet).

When the inorganic filler having a coefficient of thermal conductivity of 10 W/m·K or more is used as the inorganic filler of component (D), the amount added to the resin composition is not particularly limited and can be appropriately adjusted depending on required heat dissipation properties. For example, for achieving a coefficient of thermal conductivity of 2 W/m·K or more after curing, the amount of the inorganic filler of component (D) added to the resin composition, relative to 100 parts by mass of a total solid content of component (A), component (B), and component (C), is preferably 100 to 1200 parts by mass and more preferably 200 to 1000 parts by mass. When the added amount of component (D) is excessively large, the elastic modulus of the cured product in the low temperature region of 0°C or lower becomes high. Therefore, there is concern about the occurrence of a decrease in adhesiveness or the like.

Also, the content of the filler having a coefficient of thermal conductivity of 10 W/m·K or more is preferably 45% by volume or more and 75% by volume or less, and more preferably 50% by volume or more and 70% by volume or less, in all components, excluding a solvent, of the resin composition according to the present embodiment.

As the inorganic filler of component (D), silica is sometimes used for a purpose of decreasing the CTE. In this case, the amount of the inorganic filler of component (D) added to the resin composition, relative to 100 parts by mass of a total solid content of component (A), component (B), and component (C), is preferably 10 to 700 parts by mass and more preferably 100 to 500 parts by mass.

Also, the content of silica is preferably 5% by volume or more and 75% by volume or less, and more preferably 30% by volume or more and 70% by volume or less, in all components, excluding a solvent, of the resin composition according to the present embodiment.

The type of the inorganic filler of component (D) is not particularly limited. As the inorganic filler of component (D), one type of filler may be used, or two or more types of fillers may be used in combination. When two or more types of fillers are used, the total content and the average particle size of two or more types of fillers preferably satisfy the above-described ranges. Also, when fillers of the same type having a different average particle size are used, the total content and the average particle size preferably satisfy the above-described ranges.

The resin composition of the present embodiment may further contain a curing catalyst such as a silane coupling agent and an imidazole-based curing catalyst.

The raw materials of the resin composition according to the present embodiment include the above-described components (A) to (C), component (D) added as necessary, and other components. The resin composition of the present embodiment can be obtained by, for example, dissolving or dispersing these raw materials in an organic solvent. An apparatus for, for example, dissolving or dispersing these raw materials is not particularly limited. Examples of this apparatus to be used include a stirrer, a dissolver, a planetary mixer, a kneader, a triple roll mill, a ball mill, a bead mill, and the like, each equipped with a heater. Also, these apparatuses may be appropriately used in combination.

The resin composition of the present embodiment has suitable properties described below.

A resin cured product of the resin composition according to the present embodiment has a low elastic modulus in the low temperature region of 0°C or lower, more specifically, in the low temperature region of -40°C to 0°C. Particularly, the storage elastic modulus at -40°C of the resin composition according to the present embodiment, measured by a procedure described in the later-described example, is 15 GPa or less, preferably 10 GPa or less, and more preferably 5 GPa or less. When the storage elastic modulus is within the above-described range, a cured product of the resin composition according to the present embodiment, when used for an application such as an electronic part to be mounted on a vehicle, is less likely to cause cracks in a solder portion where an electronic part has been mounted.

The resin composition of the present embodiment can be thermally cured for 30 to 180 minutes, at a temperature of, for example, 150°C or higher and 250°C or lower, and preferably 180°C or higher and 220°C or lower.

When the inorganic filler having a coefficient of thermal conductivity of 10 W/m·K or more is used as the inorganic filler of component (D), the thermal conductivity of a resin cured product of the resin composition according to the present embodiment increases. Specifically, when a coefficient of thermal conductivity is measured by a procedure described in the later-described example, a coefficient of thermal conductivity of 2 W/m·K or more is obtained. Therefore, when the resin composition of the embodiment is used as an insulating adhesive layer to a metal base substrate plate such as an aluminum base substrate plate, heat dissipation properties are good.

A resin cured product of the resin composition according to the present embodiment has sufficient adhesive strength. Specifically, in a resin cured product of the resin composition according to the present embodiment, 70 µm copper foil adhesion, measured by a procedure described in the later-described example, is 15 N/10 mm or more and preferably 20 N/10 mm or more.

A resin cured product of the resin composition according to the present embodiment has high heat resistance. Specifically, in a solder heat resistance test performed by a procedure described in the later-described example, the heat resistance of a resin cured product of the resin composition according to the present embodiment satisfies 280°C 3min and preferably satisfies 300°C 3min.

The film with a substrate of the present embodiment includes a plastic substrate of polyester resin, polyethylene resin, polyethylene terephthalate resin, or the like and a layer that contains the resin composition of the present embodiment and that is formed at least one surface of this plastic substrate. The metal/resin laminated body of the present embodiment includes a metal plate or metal foil of copper, aluminum, or the like and a layer that contains the resin composition of the present embodiment and that is formed on at least one surface of this metal plate or metal foil. These can be obtained by coating at least one surface of the plastic substrate or the metal plate or metal foil with the resin composition of the present embodiment and thereafter drying the coat.

A method for coating the plastic substrate or the metal plate or metal foil with the resin composition is not particularly limited. However, this coating method is preferably a microgravure method, a slot die method, and a doctor blade method, from the viewpoint of thinning a film and controlling a film thickness. By a slot die method, a layer that contains the resin composition and that has a thickness of 5 to 500 µm, for example, can be formed.

The drying condition can be appropriately set depending on the type and amount of an organic solvent used in the resin composition, the coating thickness, and the like. The drying condition can be set, for example, at 50 to 120°C for about 1 to 30 minutes.

In the semiconductor device of the present embodiment, the resin composition of the present embodiment is used for interlayer adhesion between constituent elements of the semiconductor device. Specifically, for example, in the semiconductor device of the present embodiment, the resin composition of the present embodiment is used for interlayer adhesion between an electronic part and a substrate plate. Alternatively, in the semiconductor device of the present embodiment, the resin composition of the present embodiment is used in an apparatus containing an electronic part.

### EXAMPLES

Hereinafter, the present embodiment will be described in more detail by examples. However, the present embodiment is not particularly limited to these examples.

### (Examples 1 to 13 and Comparative Examples 1 to 4)

According to formulations illustrated in the following tables, predetermined amounts of elastomer resin (A-1, A-2, or A'), resin (B-1, B-2, or C), and toluene were weighed and poured in a container. The mixture was heated and dissolved using a heating stirrer and cooled to room temperature. Thereafter, predetermined amounts of a filler (D-1, D-2, or D-3) and a curing catalyst (E) were weighted and poured in the container and mixed under stirring for 3 minutes by a rotation/revolution stirrer (Mazerustar (trade name), manufactured by Kurabo Industries Ltd.). Thereafter, dispersion was performed by a wet atomizer (MN2-2000AR, manufactured by Yoshida Kikai Co., Ltd.), and viscosity adjustment was performed with toluene. Accordingly, a solution containing a resin composition was prepared.

The components used in preparing the resin composition are as follows.

### Component (A): Modified elastomer having an acid anhydride group

(A-1) Maleic anhydride-modified styrene-based elastomer (SEBS), M1913 (trade name), manufactured by Asahi Kasei Chemicals Corporation, styrene ratio 30%, acid number: 10 mg CH₃ONa/g
(A-2) Maleic anhydride-modified styrene-based elastomer (SEBS), M1943 (trade name), manufactured by Asahi Kasei Chemicals Corporation, styrene ratio 20%, acid number: 10 mg CH₃ONa/g

### Component (B): Solvent-soluble polyimide resin

(B-1): Solvent-soluble polyimide resin synthesized by the following procedure
   In a reaction vessel equipped with a stirrer, a diversion device, a thermometer, and a nitrogen gas introduction pipe, there was prepared a solution containing 210.0 g of a commercially available aromatic tetracarboxylic acid dianhydride (BTDT-UP (trade name), manufactured by Evonik Japan KK), 1008.0 g of cyclohexanone, and 201.6 g of methyl cyclohexane. Thereafter, this solution was heated to 60°C. Subsequently, 341.7 g of a commercially available dimer diamine (PRIAMINE (trade name) 1075, manufactured by Croda Japan KK) was dropped in this solution. Thereafter, an imidization reaction of this solution proceeded at 140°C over 10 hours. Thereafter, the solvent was distilled away under reduced pressure, and toluene substitution was performed. Accordingly, a solution of a solvent-soluble polyimide resin (nonvolatile content 30.1%) was obtained. As a result of GPC measurement, the number average molecular weight (Mn) was 15000.
(B-2): Solvent-soluble polyimide resin synthesized by the following procedure
   In a reaction vessel equipped with a stirrer, a diversion device, a thermometer, and a nitrogen gas introduction pipe, there was prepared a solution containing 190.0 g of a commercially available aromatic tetracarboxylic acid dianhydride (BTDT-UP (trade name), manufactured by Evonik Japan KK), 912.0 g of cyclohexanone, and 182.4 g of methyl cyclohexane. Thereafter, this solution was heated to 60°C. Subsequently, 288.1 g of a commercially available dimer diamine (PRIAMINE (trade name) 1075, manufactured by Croda Japan KK) and 24.7 g of a commercially available silicone diamine (KF-8010 (trade name), manufactured by Shin-Etsu Chemical Co., Ltd.) were dropped in this solution. Thereafter, an imidization reaction of this solution proceeded at 140°C over 10 hours. Accordingly, a polyimide resin solution (nonvolatile content 30.8%) was obtained. As a result of GPC measurement, the number average molecular weight (Mn) was 14000.

### Component (C): Epoxy resin

(C) Bisphenol A type epoxy resin, 828EL (trade name), manufactured by Mitsubishi Chemical Corporation
(A') Styrene-based elastomer (SEBS) not modified with maleic acid, G1657 (trade name), manufactured by Kraton Polymer Japan Ltd., styrene ratio 13%, acid number: 0 mg CH₃ONa/g

### Component (D): Inorganic filler

As a thermally conductive filler having a coefficient of thermal conductivity of 10 W/m·K or more, (D-1) to (D-3) were used.
(D-1): Spherical alumina, DAW-0735 (trade name), manufactured by Denka Company Limited, average particle size 7 µm
(D-2): Scaly boron nitride, Platelets 0075 (trade name), manufactured by 3M Japan Ltd., average particle size 7.5 µm
(D-3): Aggregated boron nitride, FP-40 (trade name), manufactured by Denka Company Limited, average particle size 40 µm

### Component (E): Curing catalyst

(E): Imidazole-based curing catalyst, 2-phenyl-4,5-dihydroxymethylimidazole, 2PHZ-PW (trade name), manufactured by Shikoku Chemicals Corporation
The resin compositions prepared by the above-described procedure were evaluated as below.

### 1. Storage elastic modulus (-40°C)

The solution containing the resin composition obtained by the above-described procedure was applied on one surface of a plastic substrate (a PET film subjected to mold releasing treatment) and dried at 100°C for 5 minutes. Accordingly, a sheet having a thickness of about 100 µm was prepared. The prepared sheet was press cured for 60 minutes under the conditions of 200°C and 5 MPa thereby to obtain a resin cured product. This resin cured product was cut out into a 40 mm × 10 mm strip-like shape. Using a DMS6100 manufactured by SII Nano Technology Inc., the storage elastic modulus at -40°C of the strip-like resin cured product was obtained.

The obtained result was evaluated according to the following criteria.

### Storage elastic modulus (-40°C)

A 5 GPa or less
B More than 5 GPa and 10 GPa or less
C More than 10 GPa and 15 GPa or less
D More than 15 GPa

### 2. Coefficient of thermal conductivity

The solution containing the resin composition obtained by the above-described procedure was applied on one surface of a plastic substrate (a PET film subjected to mold releasing treatment) and dried at 100°C for 5 minutes. Accordingly, a sheet having a thickness of about 100 µm was prepared. Four of the prepared sheets were laminated and press cured for 60 minutes under the conditions of 200°C and 5 MPa thereby to obtain a resin cured product. This was cut into 10 mm × 10 mm. Using a coefficient of thermal conductivity measuring device (LFA447 Nanoflash, manufactured by NETZSCH Co.), the coefficient of thermal conductivity in the cut resin cured product was measured.

### 3. 70 µm copper foil adhesion

The solution containing the resin composition obtained by the above-described procedure was applied on one surface of a plastic substrate (a PET film subjected to mold releasing treatment) and dried at 100°C for 5 minutes. Accordingly, a sheet having a thickness of about 100 µm was prepared. The prepared sheet was placed between coarsened surfaces of 70 µm thick copper foil (CF-T8G-THE-70 (trade name), manufactured by Fukuda Metal Foil & Powder Co., Ltd.) and pressed for 60 minutes under the conditions of 200°C and 5 MPa. The pressed test piece was cut into a 10 mm width. Using the cut test piece, adhesion when the copper foil was peeled at a peel angle of 180 degrees was measured by an autograph.

The obtained result was evaluated according to the following criteria.
A 25 N/10 mm or more
B 15 N/10 mm or more and less than 25 N/10 mm
C Less than 15 N/10 mm

### 4. Solder heat resistance

The solution containing the resin composition obtained by the above-described procedure was applied on one surface of a plastic substrate (a PET film subjected to mold releasing treatment) and dried at 100°C for 5 minutes. Accordingly, a sheet having a thickness of about 100 µm was prepared. The prepared sheet was placed between coarsened surfaces of 18 µm thick copper foil (CF-T9FZ-SV-18 (trade name), manufactured by Fukuda Metal Foil & Powder Co., Ltd.) and pressed for 60 minutes under the conditions of 200°C and 5 MPa. The pressed test piece was cut into 25mm × 25mm. The cut test piece was floated on a solder bath at 280°C and 300°C for 3 minutes. Thereafter, it was checked if a blister (a 3 minutes blister) occurred.

The obtained result was evaluated according to the following criteria.
A No blister for 3 minutes at 300°C
B No blister for 3 minutes at 280°C
C A blister occurred within 3 minutes at 280°C.

The results are illustrated in tables below.

**[Table 1]**

| | | Example 1 | Example 2 | Example 2 | Example 4 | Example 5 | Example 6 |
|---|---|---|---|---|---|---|---|
| **Components** | (A-1) | - | - | - | - | - | - |
| | (A-2) | 85.5 | 85.5 | 85.5 | 85.5 | 85.5 | 85.5 |
| | (B-1) | 9.5 | 9.5 | 9.5 | - | 9.5 | 9.5 |
| | (B-2) | - | - | | 9.5 | | |
| | (C) | 5 | 5 | 5 | 5 | 5 | 5 |
| | (A') | - | - | - | - | - | - |
| | (D-1) | 792 | 792 | 978 | 792 | 380 | 117 |
| | (D-2) | - | - | - | - | 121 | - |
| | (D-3) | - | - | - | - | - | 161 |
| | (D) vol% | 67.0 | 67.0 | 71.5 | 67.0 | 60.0 | 50.0 |
| | (E) | - | 0.015 | 0.15 | - | 0.15 | - |
| | Storage elastic modulus (-40°C, GPa) | Good (7.7) | Good (9.9) | Good (7.4) | Good (9.9) | Good (5.3) | Excellent (4.5) |
| | Coefficient of thermal conductivity (W/m×K) | 2.5 | 2.5 | 3.1 | 2.4 | 3.0 | 3.0 |
| | 70 mm copper foil adhesion (N/10 mm) | Excellent (30) | Excellent (30) | Good (16) | Good (24) | Good (16) | Good (20) |
| | Solder heat resistance | Good | Good | Good | Good | Good | Good |

**[Table 2]**

| | | Example 7 | Example 8 | Example 9 | Example 10 | Example 11 | Example 12 | Example 13 |
|---|---|---|---|---|---|---|---|---|
| Components | (A-1) | - | - | - | - | 85.5 | - | - |
| | (A-2) | 81.0 | 90.0 | 93 | 88 | | 70.0 | 45.0 |
| | (B-1) | 9 | 5 | 2 | 10 | 9.5 | 25 | 50 |
| | (B-2) | | | | | | | |
| | (C) | 10 | 5 | 5 | 2 | 5 | 5 | 5 |
| | (A') | - | - | - | - | - | - | - |
| | (D-1) | 792 | 792 | 792 | 792 | 792 | 792 | 792 |
| | (D-2) | - | - | - | - | - | - | - |
| | (D-3) | - | - | - | - | - | - | - |
| | (D) vol% | 67.0 | 67.0 | 67.0 | 67.0 | 67.0 | 67.0 | 67.0 |
| | (E) | - | - | - | - | - | - | - |
| | Storage elastic modulus (-40°C, GPa) | Good (6.4) | Good (7.3) | Good (7.3) | Good (9.1) | Fair (12) | Good (9.3) | Fair (15) |
| | Coefficient of thermal conductivity (W/m×K) | 2.5 | 2.6 | 2.5 | 2.7 | 2.7 | 2.7 | 2.9 |
| | 70 mm copper foil adhesion (N/10 mm) | Good (22) | Excellent (30) | Excellent (30) | Excellent (27) | Excellent (27) | Good (24) | Good (20) |
| | Solder heat resistance | Good | Good | Good | Good | Good | Good | Fair |

**[Table 3]**

| | | Comparative Example 1 | Comparative Example 2 | Comparative Example 3 | Comparative Example 4 |
|---|---|---|---|---|---|
| Components | (A-1) | - | - | - | - |
| | (A-2) | 95.0 | 90.0 | - | - |
| | (B-1) | - | 10 | 9.5 | 95 |
| | (B-2) | | | | |
| | (C) | 5 | - | 5 | 5 |
| | (A') | - | - | 85.5 | - |
| | (D-1) | 910 | 792 | 792 | 792 |
| | (D-2) | - | - | - | - |
| | (D-3) | - | - | - | - |
| | (D) vol% | 70.0 | 67.0 | 67.0 | 67.0 |
| | (E) | 0.5 | 1 | 0.15 | - |
| | Storage elastic modulus (-40°C, GPa) | Good (5.5) | Good (8.8) | Good (5.7) | Poor (16) |
| | Coefficient of thermal conductivity (W/m×K) | 2.5 | 2.8 | 2.4 | 2.8 |
| | 70 mm copper foil adhesion (N/10 mm) | Good (24) | Good (16) | Poor (11) | Good (24) |
| | Solder heat resistance | Poor | Poor | Poor | Poor |

In all of Examples 1 to 13, the storage elastic modulus at -40°C was 15 GPa or less, the coefficient of thermal conductivity was 2 W/m·K or more, and the 70 µm copper foil adhesion was 15 N/10 mm or more. Also, in the solder heat resistance evaluation, 280°C 3 min was achieved. It is noted that for the make-ups in all of Examples 1 to 13, the storage elastic modulus at 23°C was 5 GPa or less.

It is noted that Example 2 is an example in which to Example 1, the curing catalyst of component (E) was further added. Example 3 is an example in which to Example 2, the formulation ratios of the inorganic filler of component (D) and the curing catalyst of component (E) were changed. Example 4 is an example in which to Example 1, the type of the solvent-soluble polyimide of component (B) was changed. Example 5 is an example in which to Example 2, scaly boron nitride was further used as the inorganic filler of component (D), and the formulation ratio of the inorganic filler of component (D) was changed. Example 6 is an example in which to Example 1, aggregated boron nitride was used in combination as the inorganic filler of component (D), and the formulation ratio of the inorganic filler of component (D) was changed. Examples 7 and 10 are examples in which to Example 1, the formulation ratios of the modified elastomer having an acid anhydride group of component (A), the solvent-soluble polyimide of component (B), and the epoxy resin of component (C) were changed. Examples 8, 9, 12, and 13 are examples in which to Example 1, the formulation ratios of the modified elastomer having an acid anhydride group of component (A) and the solvent-soluble polyimide of component (B) were changed. Example 11 is an example in which to Example 1, the type of the modified elastomer having an acid anhydride group of component (A) was changed.

Comparative Example 1 is a comparative example in which the solvent-soluble polyimide of component (B) is not formulated. In Comparative Example 1, the numerical value obtained in the solder heat resistance evaluation was less than 280°C 3min. Comparative Example 2 is a comparative example in which the epoxy resin of component (C) is not formulated. In Comparative Example 2, the numerical value obtained in the solder heat resistance evaluation was less than 280°C 3min. Comparative Example 3 is a comparative example in which a styrene-based elastomer not modified with maleic acid is formulated instead of the modified elastomer having an acid anhydride group of component (A). In Comparative Example 3, the 70 µm copper foil adhesion was less than 15 N/10 mm, and the numerical value obtained in the solder heat resistance evaluation was less than 280°C 3min. Comparative Example 4 is a comparative example in which the modified elastomer having an acid anhydride group of component (A) is not formulated. In Comparative Example 4, the storage elastic modulus at -40°C was more than 15 GPa, and the numerical value obtained in the solder heat resistance evaluation was less than 280°C 3min.

## Claims

1. A resin composition, comprising:
(A) a modified elastomer having an acid anhydride group;
(B) a solvent-soluble polyimide resin; and
(C) an epoxy resin, wherein
the (B) is a polyimide resin obtained by causing a tetracarboxylic acid component and dimer diamine to react.

2. The resin composition according to claim 1,
wherein the (A) is a maleic anhydride-modified styrene-based elastomer.

3. The resin composition according to any of claims 1 or 2,
wherein a content of the (A) is 40% by mass or more, in terms of % by mass relative to a total solid content mass of the (A), the (B), and the (C).

4. The resin composition according to any of claims 1 to 3, further comprising
(D) an inorganic filler.

5. The resin composition according to claim 4,
wherein the (D) is a thermally conductive filler having a coefficient of thermal conductivity of 10 W/m·K or more.

6. A film with a substrate, comprising:
a plastic substrate; and
a layer that includes the resin composition according to any of claims 1 to 5 and that is formed on at least one surface of the plastic substrate.

7. A metal/resin laminated body, comprising:
a metal plate or metal foil; and
a layer that includes the resin composition according to any of claims 1 to 5 and that is formed on at least one surface of the metal plate or metal foil.

8. A resin cured product which is a cured product of the resin composition according to any of claims 1 to 5.

9. A semiconductor device including the resin composition according to any of claims 1 to 5.

## Patentansprüche

1. Eine Harzzusammensetzung, die folgende Merkmale aufweist:
(A) ein modifiziertes Elastomer mit einer Säureanhydridgruppe;
(B) ein lösungsmittellösliches Polyimidharz; und
(C) ein Epoxidharz, wobei
das (B) ein Polyimidharz ist, das dadurch erhalten wird, dass eine Reaktion zwischen einer Tetracarbonsäurekomponente und Dimerdiamin verursacht wird.

2. Die Harzzusammensetzung gemäß Anspruch 1,
bei der das (A) ein Maleinsäureanhydrid-modifiziertes Styrol-basiertes Elastomer ist.

3. Die Harzzusammensetzung gemäß einem der Ansprüche 1 oder 2,
bei der ein Gehalt des (A) hinsichtlich Masseprozent relativ zu einer Gesamtmasse des Feststoffgehalts des (A), des (B) und des (C) 40 Masseprozent oder mehr beträgt.

4. Die Harzzusammensetzung gemäß einem der Ansprüche 1 bis 3, die ferner (D) einen anorganischen Füllstoff aufweist.

5. Die Harzzusammensetzung gemäß Anspruch 4,
bei der das (D) ein thermisch leitender Füllstoff ist, der einen Wärmeleitfähigkeitskoeffizienten von 10 W/m·K oder mehr aufweist.

6. Ein Film mit einem Substrat, der folgende Merkmale aufweist:
ein Kunststoffsubstrat; und
eine Schicht, die die Harzzusammensetzung gemäß einem der Ansprüche 1 bis 5 umfasst und die auf zumindest einer Oberfläche des Kunststoffsubstrats gebildet ist.

7. Ein Metall/Harz-laminierter Körper, der folgende Merkmale aufweist:
eine Metallplatte oder Metallfolie; und
eine Schicht, die die Harzzusammensetzung gemäß einem der Ansprüche 1 bis 5 umfasst und die auf zumindest einer Oberfläche der Metallplatte oder Metallfolie gebildet ist.

8. Ein harzgehärtetes Produkt, das ein gehärtetes Produkt der Harzzusammensetzung gemäß einem der Ansprüche 1 bis 5 ist.

9. Eine Halbleitervorrichtung, die die Harzzusammensetzung gemäß einem der Ansprüche 1 bis 5 umfasst.

## Revendications

1. Composition de résine, comprenant:
(A) un élastomère modifié présentant un groupe anhydride d'acide;
(B) une résine polyamide soluble dans un solvant; et
(C) une résine époxy,
dans laquelle
la (B) est une résine polyamide obtenue en faisant réagir un composant d'acide tétracarboxylique et une diamine de dimère.

2. Composition de résine selon la revendication 1,
dans laquelle (A) est un élastomère à base de styrène modifié par de l'anhydride maléique.

3. Composition de résine selon l'une quelconque des revendications 1 ou 2,
dans laquelle la teneur en (A) est de 40 % en masse ou plus, en termes de % en masse par rapport à la masse du contenu total de matières solides de (A), de (B) et de (C).

4. Composition de résine selon l'une quelconque des revendications 1 à 3, comprenant par ailleurs (D) une charge inorganique.

5. Composition de résine selon la revendication 4,
dans laquelle (D) est une charge conductrice de chaleur présentant un coefficient de conductivité thermique de 10 W/m-K ou plus.

6. Film avec un substrat, comprenant:
un substrat en plastique; et
une couche qui comporte la composition de résine selon l'une quelconque des revendications 1 à 5 et qui est formée sur au moins une surface du substrat en plastique.

7. Corps stratifié en métal/résine, comprenant:
une plaque métallique ou une feuille métallique; et
une couche qui comporte la composition de résine selon l'une quelconque des revendications 1 à 5 et qui est formée sur au moins une surface de la plaque métallique ou de la feuille métallique.

8. Produit durci à base de résine qui est un produit durci de la composition de résine selon l'une quelconque des revendications 1 à 5.

9. Dispositif semi-conducteur comportant la composition de résine selon l'une quelconque des revendications 1 à 5.
